# EUROPEAN PATENT SPECIFICATION

(11) **EP 3 139 412 B1**
(45) Date of publication and mention of the grant of the patent: **13.06.2018**
(21) Application number: 16187266.8
(22) Date of filing: 05.09.2016
(51) Int. Cl.: H01L 31/0203, H01L 33/44, H01L 33/52, H01L 33/00, G01J 1/04, G01J 5/04, G01J 1/42

(54) **OPTOELECTRONIC DEVICE AND METHOD FOR PRODUCING THE SAME**
OPTOELEKTRONISCHES BAUELEMENT UND VERFAHREN ZU DESSEN HERSTELLUNG
DISPOSITIF OPTOÉLECTRONIQUE ET SON PROCÉDÉ DE FABRICATION

(30) Priority: 04.09.2015 DE 102015114890
(43) Date of publication of application: 08.03.2017
(73) Proprietor: IDT Europe GmbH, 01109 Dresden (DE)
(72) Inventor: GARZAROLLI, Matthias, 01309 Dresden (DE); KUNKEL, Stefan, 85586 Poing (DE); DELIGA, Jörg, 01109 Dresden (DE); REICHEL, Thomas, 01277 Dresden (DE); DOSSI, Roberto, 01108 Dresden (DE)
(74) Representative: Lippert Stachow Patentanwälte Rechtsanwälte

(56) References cited:
- DE-A1-102008 005 936
- JP-A- H07 142 766
- US-A1- 2005 199 990
- US-A1- 2006 164 959
- US-A1- 2007 272 932
- C.A. DORVAL DION ET AL: "Photo-initiated chemical vapor deposition as a scalable particle functionalization technology (a practical review)", POWDER TECHNOLOGY, vol. 239, 1 May 2013 (2013-05-01), pages 484-491, XP055310566, CH ISSN: 0032-5910, DOI: 10.1016/j.powtec.2013.02.024

## Description

The invention relates to an optoelectronic device in accordance with the appended claim 1, namely: an optoelectronic device comprising a semiconductor element which has an optically active surface and a cover which surrounds the semiconductor element at least on its optically active surface, wherein the cover comprises a cover material which is transparent for a determined wavelength, wherein a top surface of the cover laying opposite to the optically active surface of the semiconductor element is covered by a blocker layer, wherein said blocker layer is transparent for the determined wavelength and comprises a gas- and/ or moisture-impermeable material, wherein the blocker layer comprises an inorganic material, and wherein the blocker layer comprises a metal layer, in particular from Al, CrNi, Ti or Ta. The invention also relates to a process in accordance with the appended claim 8 for the preparation of an optoelectronic device of the aforementioned type.

Optoelectronic devices can be any kind of light emitting or light absorbing devices or components. In any case, they comprise a semiconductor element which has the corresponding photo-active property. Thus for instance, light emitting diodes, photodiodes and photo transistors are known. The semiconductor element is at least partially provided with an optically active surface, whereas said optically active surface emits light or absorbs incident light that leads to an electrical response.

The semiconductor element must always be protected against environmental influences. To protect against such influences, prior art documents US 2006/0164959 A1, DE 10 2008 005 936 A1, US 2005/0199990 A1 and JP H07-142766 A disclose various optoelectronic device packages, wherein the optoelectronic chip is first encapsulated and then the encapsulant covered by an inorganic material-based protection layer of, typically, SiO₂ (in addition to silicon dioxide, US 2006/0164959 A1 also discloses silicon nitride, magnesium fluoride or tantalum oxide as alternative materials). For this purpose, the semiconductor element is covered at least on its optically active surface with a cover material. In order to use the optically active surface of the semiconductor element, meaning that the optically active surface will be effective, it is necessary that a cover material is selected which is transparent. The optoelectronic devices are always effective in a certain wavelength range, wherein for each wavelength, in which the optoelectronic device is active, i.e. emitting light or detecting light, said wavelength is referred to as determined wavelength. Accordingly, the cover material is designed or selected such that it is transparent to the corresponding determined wavelength or wavelengths. So it is quite possible to use black appearing material for example in the visible light range, but said material is transparent for infrared light and thus can be used for example for infrared diodes.

The cover material is also called mold compound and thereto corresponding transparent mold compounds are called clear mold compounds.

The disadvantage of already known cover materials or clear mold compounds is that the optical properties of these materials change. In particular, the transmissivity of these material reduces. Furthermore, the change in transmissivity is not the same in all wavelengths. The degradation can be stronger or less strong in different wavelength ranges.

In the design of optoelectronic devices as sensors the aging of the cover material is disadvantageous, as thus the sensor characteristics alter.

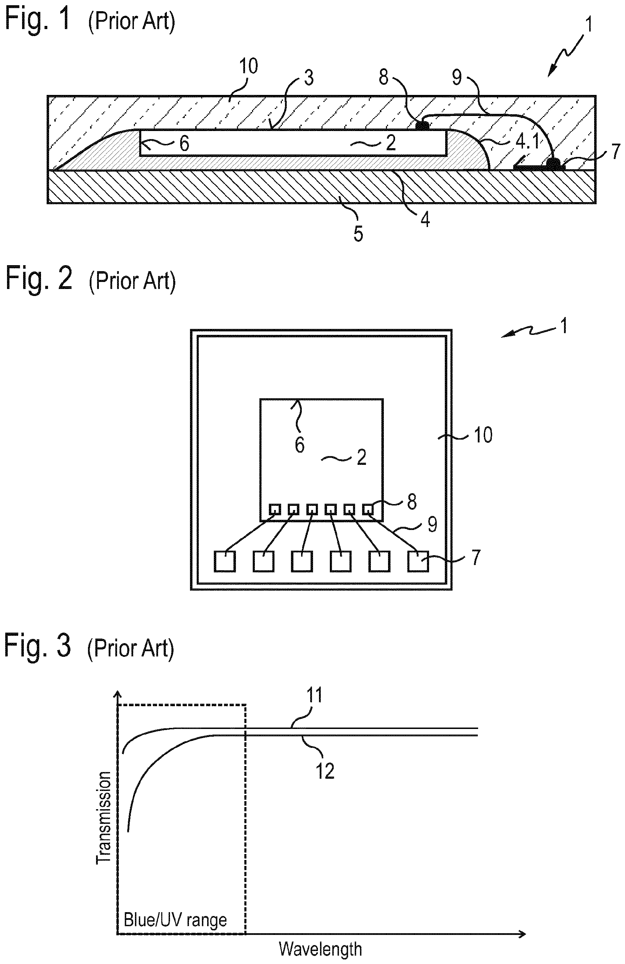

Figure 1 shows a sectional view of a sensor 1 for ultraviolet radiation, short: UV-sensor. Figure 2 shows a top view of this sensor. The sensor comprises a semiconductor element 2 with an optically active surface 3.

The semiconductor element 2 is bonded to a substrate 5 by an adhesive (a die attach material) 4. In addition a side cover material is provided. Said side cover material is opaque for the determined wavelength, and covers the side surfaces 6 which are vertically extended to the optically active surface 3 of the semiconductor element 2. This prevents that light may incident laterally into the semiconductor element 2, because this light fraction would distort the sensor result or sensor signal.

On the substrate 5 are also interconnects 7 to outer connection of the sensor 1. Bonding pads 8 on the semiconductor element 2 are connected via bonding wires 9 to the interconnects 7.

To cover the optically active surface 3 and for mechanical fixing for both the bonding wires 9 and the protection of the semiconductor element 2 a cover material 10 is provided whereas said cover is a clear mold compound.

Figure 3 shows an aging behavior of the cover material 10 for the UV-sensor shown in figures 1 and 2. This cover material 10 is in principle well suited for optoelectronic devices, but especially shows in the range of ultraviolet light (UV range) signs of aging.

The transmissivity of the cover material deviates significantly from the initial state, i.e. immediately after the production of the sensor 1, illustrated by curve 11, and after an aging period, illustrated by curve 12.

This aging behavior leads to a distortion of the detected results or values of the sensor 1.

Cover materials of other optoelectronic devices show similar signs of aging in other wavelength ranges, which can also lead to other changes, such as the change in spectrum of light emitting devices.

The object of the invention is therefor, to reduce the aging of optoelectronic devices.

This object is achieved by an optoelectronic device of the type mentioned above, i.e. in accordance with the appended claim 1, in which a top surface of the cover laying opposite to the optically active surface of the semiconductor element is covered by a blocker layer, wherein said blocker layer is transparent for the determined wavelength and comprises a gas- and/or moisture-impermeable material, wherein the blocker layer comprises an inorganic material, and wherein the blocker layer comprises a metal layer, in particular from Al, CrNi, Ti or Ta. It is believed that aging is caused by various environmental factors such as moisture, atmospheric oxygen or other environmental gases, accompanied by effects of temperature and light radiation. It has been found out that a permeation barrier or a blocker layer of a gas- and / or moisture-impermeable material significantly reduces the signs of aging due to these environmental influences or can even prevent these signs of aging.

In the cases where the incidence or the emission of radiation at the side surfaces of the semiconductor element may be disregarded for the function of the optoelectronic device, the coating of the top surface of the semiconductor element may be sufficient, even if the side surfaces should still lead to a spatially limited aging.

In one embodiment of the invention the cover comprises the top surface and vertically extended laterally adjacent to the semiconductor element laying side surfaces and the blocker layer is also applied to the side surfaces. Thus, a change of the transmissivity caused by incident or emitted radiation from the side surfaces can be restrained or completely prevented. According to the present invention, the blocking layer comprises an inorganic material, namely it comprises a metal layer, in particular from Al, CrNi, Ti or Ta. Just inorganic materials can have good permeation-preventing properties and are designed optically transparent. In accordance with the present invention, the blocking layer comprises a metal layer of, in particular, Al, CrNi, Ti or Ta. Although these materials should be opaque per se for determined wavelengths, a transparency can still be achieved over a very small thickness of a few microns, despite the effect of being a moisture or gas barrier.

Furthermore, the blocking layer in accordance with the present invention, i.e. comprising a metal layer, may further comprise a metal oxide. In particular, the metal oxide can be provided from one of the metals Al, CrNi, Ti or Ta. The inorganic material-containing blocking layer in accordance with the present invention, i.e. comprising a metal layer, may also be realized such that the blocker layer further contains SiO₂. This material lends itself because it is already used in many process steps of the production of semiconductors.

The blocking layer in accordance with the present invention, i.e. comprising a metal layer, may be formed as a gradient layer with varying stoichiometric properties from the outside of the semiconductor element to the outside of the blocking layer.

For example, the region near the semiconductor element with respect to oxygen deliberately kept sub-stoichiometric. Therefore, this region has still an oxygen affinity, thereby penetrating oxygen from the outer layer regions can be effectively stopped before the oxygen may come in contact with the cover material.

Depending on the strength of environmental influences and for the best possible design of the manufacturing process, the blocking layer is formed as a layer system with multiple sub-layers of different materials or with varying stoichiometric properties.

The object of the invention can also be achieved by a method for producing the optoelectronic device in accordance with the present invention; method in which after producing the cover of the optoelectronic device, a coating process in the form of a reactive sputtering, a PVD (physical vapor deposition) process or a coating process outside a vacuum is subjected to said cover, whereby the blocker layer is deposited. Such coating processes are carried out in vacuum whereas material is dissolved out from a target, which then is deposited in the case of reactive processes in chemically modified form, on the surface of the optoelectronic device.

This method can be provided such that before the coating process is performed, the surfaces which should not be covered by the blocker layer are covered by a mask, wherein said mask is removed after the coating process together with the deposited blocker layer on said mask. This solution is particularly appropriate when the blocking layer should have an influence on the optoelectronic properties of the semiconductor element due to its permeation-properties, for example, a change in the capacity of electrically conductive blocker layers. This effect may be reduced.

The invention will be explained in more detail using exemplary embodiments. The appended drawings show
- Fig. 1: a sectional view of a sensor of ultraviolet radiation according to the prior art;
- Fig. 2: a plan view of the UV-sensor;
- Fig. 3: an aging behavior of the cover material for the UV - sensor shown in Fig. 1 and Fig. 2;
- Fig. 4: a sectional view of a sensor according to the invention with a top-side blocking layer, and
- Fig. 5: a sectional view of a sensor of the invention with an all-round blocker layer.

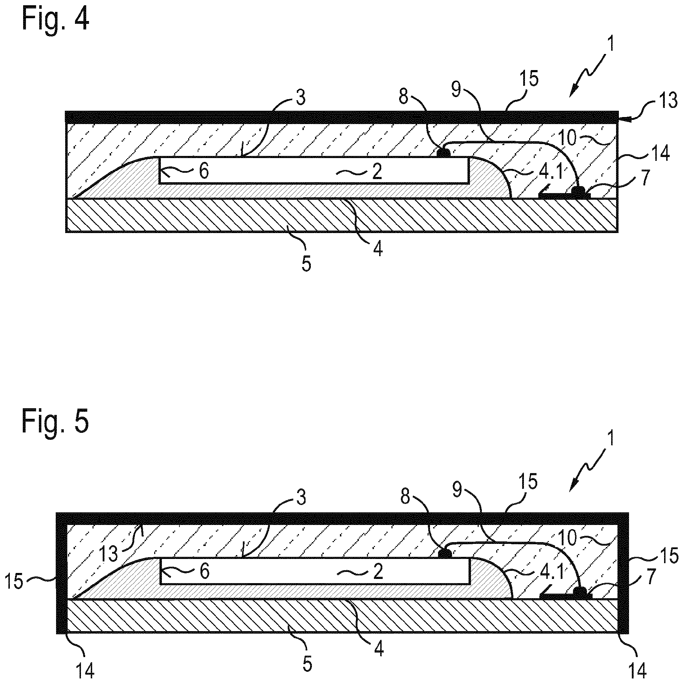

Figures 4 and 5, each show an inventive optoelectronic device represented in the form of a light sensor. This light sensor has the same components as have already been described in the prior art to figs. 1 and 2. For this reason, figs. 4 and 5 are also provided with the same reference numerals.

The cover 10 has a top surface 13 laying opposite to the optically active surface 3 of the semiconductor element 2 and vertically extended laterally adjacent to the semiconductor element 2 laying side surfaces.

In order to prevent aging of the cover material, as shown in figure 3, a blocking layer 15 in accordance with the present invention is applied to the top surface 13 in the example of figure 4. Thus, the side surfaces 14 are still exposed to environmental influences. However, since the aging also progresses spatially in the material of the cover 10, an aging of the side surfaces 14 will be here only very slowly, or may not even reach the material of the cover 10 in the area of the optically active surface. In these cases, this technologically less complex form of the coating can be selected.

To avoid any aging also from the side surfaces 14, the blocking layer 15 in accordance with the present invention can be applied also to the side surfaces 14, as shown in figure 5.

The blocking layer 15 causes a reduction or prevention of the transmission in the mold mass of the cover 10, whereby the object of the invention is fulfilled.

### Reference numerals

- 1: Optoelectronic device, e.g. a sensor
- 2: Semiconductor element
- 3: Optically active layer
- 4: Adhesive or die attach material
- 4.1: side cover material
- 5: Substrate
- 6: Side surface
- 7: Interconnection
- 8: Bond pad
- 9: Bond wire
- 10: Cover
- 11: Transmission curve at the beginning
- 12: Transmission curve after aging
- 13: Top surface of the cover
- 14: Side surface
- 15: Blocker layer

## Claims

1. Optoelectronic device comprising a semiconductor element (2) which has an optically active surface (3) and a cover (10) which surrounds the semiconductor element (2) at least on its optically active surface (3), wherein the cover (10) comprises a cover material which is transparent for a determined wavelength, wherein a top surface (13) of the cover (10) laying opposite to the optically active surface (3) of the semiconductor element (2) is covered by a blocker layer (15), wherein said blocker layer (15) is transparent for the determined wavelength and comprises a gas- and/or moisture-impermeable material, wherein the blocker layer (15) comprises an inorganic material,
**characterized in that** the blocker layer (15) comprises a metal layer, in particular from Al, CrNi, Ti or Ta.

2. Optoelectronic device according to claim 1, wherein the cover (10) comprises the top surface (13) and vertically extended laterally adjacent to the semiconductor element (2) laying side surfaces (14) and the blocker layer (15) is also applied to the side surfaces (14).

3. Optoelectronic device according to one of the former claims, wherein the blocker layer (15) further comprises a metal oxide.

4. Optoelectronic device according to claim 3, wherein the metal oxide comprises one of the metals Al, CrNi, Ti or Ta.

5. Optoelectronic device according to one of the claims 1 to 2, wherein the blocker layer (15) further comprises SiO₂.

6. Optoelectronic device according to one of the claims 1 to 5, wherein the blocking layer (15) is formed as a gradient layer with varying stoichiometric properties from the outside of the semiconductor element (2) to the outside of the blocking layer (15).

7. Optoelectronic device according to one of the claims 1 to 6, wherein the blocking layer (15) is formed as a layer system with multiple sub-layers of different materials or with varying stoichiometric properties.

8. A method for producing the optoelectronic device according to any of claims 1 to 7, wherein after producing the cover (10) of the optoelectronic device, a coating process in the form of a reactive sputtering, a PVD (physical vapor deposition) process or a coating process outside a vacuum is subjected to said cover, whereby the blocker layer (15) is deposited.

9. The method according to claim 8, wherein before the coating process is performed, the surfaces which should not be covered by the blocker layer (15) are covered by a mask, wherein said mask is removed after the coating process together with the deposited blocker layer on said mask.

## Patentansprüche

1. Optoelektronisches Bauelement, umfassend ein Halbleiterelement (2), das eine optisch aktive Oberfläche (3) und eine Abdeckung (10) aufweist, die das Halbleiterelement (2) zumindest auf seiner optisch aktiven Oberfläche (3) umgibt, wobei die Abdeckung (10) ein Abdeckmaterial umfasst, das für eine bestimmte Wellenlänge transparent ist, wobei eine Oberseite (13) der Abdeckung (10), die gegenüber der optisch aktiven Oberfläche (3) des Halbleiterelements (2) liegt, von einer Blockerschicht (15) abgedeckt wird, wobei die Blockerschicht (15) für die bestimmte Wellenlänge transparent ist und ein gas- und/oder feuchtigkeitsundurchlässiges Material umfasst, wobei die Blockerschicht (15) ein anorganisches Material umfasst,
**dadurch gekennzeichnet, dass** die Blockerschicht (15) eine Metallschicht, insbesondere aus Al, CrNi, Ti oder Ta umfasst.

2. Optoelektronisches Bauelement nach Anspruch 1, wobei die Abdeckung (10) die Oberseite (13) und vertikal gestreckte, seitlich neben dem Halbleiterelement (2) liegende Seitenflächen (14) umfasst und die Blockerschicht (15) auch auf den Seitenflächen (14) aufgebracht ist.

3. Optoelektronisches Bauelement nach einem der vorhergehenden Ansprüche, wobei die Blockerschicht (15) ferner ein Metalloxid umfasst.

4. Optoelektronisches Bauelement nach Anspruch 3, wobei das Metalloxid eines der Metalle Al, CrNi, Ti oder Ta umfasst.

5. Optoelektronisches Bauelement nach einem der Ansprüche 1 bis 2, wobei die Blockerschicht (15) ferner SiO₂ umfasst.

6. Optoelektronisches Bauelement nach einem der Ansprüche 1 bis 5, wobei die Blockerschicht (15) als Gradientenschicht mit variierenden stöchiometrischen Eigenschaften von der Außenseite des Halbleiterelements (2) zur Außenseite der Blockerschicht (15) ausgebildet ist.

7. Optoelektronisches Bauelement nach einem der Ansprüche 1 bis 6, wobei die Blockerschicht (15) als ein Schichtsystem mit mehreren Unterschichten aus unterschiedlichen Materialien oder mit variierenden stöchiometrischen Eigenschaften ausgebildet ist.

8. Verfahren zur Herstellung eines optoelektronischen Bauelements nach einem der Ansprüche 1 bis 7, wobei nach der Herstellung der Abdeckung (10) des optoelektronischen Bauelements die Abdeckung einem Beschichtungsverfahren in Form von reaktivem Sputtern, eines physikalischen Dampfabscheidungsverfahrens (PVD) oder eines Beschichtungsverfahrens außerhalb eines Vakuums unterworfen wird, wodurch die Blockerschicht (15) abgeschieden wird.

9. Verfahren nach Anspruch 8, wobei vor Durchführung des Beschichtungsverfahrens die Oberflächen, die nicht von der Blockerschicht (15) abgedeckt werden sollen, mit einer Maske verdeckt werden, wobei die Maske nach dem Beschichtungsverfahren zusammen mit der abgeschiedenen Blockerschicht auf der Maske entfernt wird.

## Revendications

1. Dispositif optoélectronique comprenant un élément semi-conducteur (2) qui a une surface optiquement active (3) et un capot (10) qui entoure l'élément semi-conducteur (2) au moins sur sa surface optiquement active (3), dans lequel
le capot (10) comprend un matériau de capot qui est transparent pour une longueur d'onde déterminée, dans lequel
une surface supérieure (13) du capot (10) se trouvant à l'opposé de la surface optiquement active (3) de l'élément semi-conducteur (2) est recouverte d'une couche de blocage (15), dans lequel
ladite couche de blocage (15) est transparente pour la longueur d'onde déterminée et comprend un matériau imperméable aux gaz et/ou à l'humidité, dans lequel
la couche de blocage (15) comprend un matériau inorganique,
**caractérisé en ce que** la couche de blocage (15) comprend une couche de métal, en particulier d'Al, CrNi, Ti ou Ta.

2. Dispositif optoélectronique selon la revendication 1, dans lequel le capot (10) comprend la surface supérieure (13) et des surfaces latérales (14) se prolongeant verticalement latéralement adjacentes à l'élément semi-conducteur (2) et la couche de blocage (15) est également appliquée aux surfaces latérales (14) .

3. Dispositif optoélectronique selon une des revendications précédentes, dans lequel la couche de blocage (15) comprend en outre un oxyde métallique.

4. Dispositif optoélectronique selon la revendication 3, dans lequel l'oxyde métallique comprend un des métaux Al, CrNi, Ti ou Ta.

5. Dispositif optoélectronique selon une des revendications 1 à 2, dans lequel la couche de blocage (15) comprend en outre du SiO₂.

6. Dispositif optoélectronique selon une des revendications 1 à 5, dans lequel la couche de blocage (15) est formée comme une couche à gradient avec des propriétés stoechiométriques variables depuis l'extérieur de l'élément semi-conducteur (2) jusqu'à l'extérieur de la couche de blocage (15).

7. Dispositif optoélectronique selon une des revendications 1 à 6, dans lequel la couche de blocage (15) est formée comme un système de couches avec de multiples sous-couches de différents matériaux ou avec des propriétés stoechiométriques variables.

8. Procédé de production du dispositif optoélectronique selon l'une quelconque des revendications 1 à 7, dans lequel après la production du capot (10) du dispositif optoélectronique, un procédé de revêtement sous la forme d'une pulvérisation cathodique réactive, d'un procédé de PVD (dépôt physique en phase vapeur) ou d'un procédé de revêtement hors d'un vide est soumis audit capot, moyennant quoi la couche de blocage (15) est déposée.

9. Procédé selon la revendication 8, dans lequel avant que le procédé de revêtement soit effectué, les surfaces qui ne devraient pas être recouvertes par la couche de blocage (15) sont recouvertes par un masque, ledit masque étant retiré après le procédé de revêtement conjointement avec la couche de blocage déposée sur ledit masque.
